# EUROPEAN PATENT SPECIFICATION

(11) **EP 3 667 760 B1**
(45) Date of publication and mention of the grant of the patent: **09.12.2020**
(21) Application number: 18211687.1
(22) Date of filing: 11.12.2018
(51) Int. Cl.: H01M 2/10, G01R 31/36, H01M 2/20, H01M 10/42, H01M 10/48

(54) **BATTERY MODULE**
BATTERIEMODUL
MODULE DE BATTERIE

(43) Date of publication of application: 17.06.2020
(73) Proprietor: Samsung SDI Co., Ltd., Gyeonggi-do 17084 (KR)
(72) Inventor: Erhart, Michael, 8054 Seiersberg-Pirka (AT)
(74) Representative: Gulde & Partner

(56) References cited:
- EP-A1- 3 063 824
- CN-U- 207 233 847
- US-A1- 2017 133 724
- US-A1- 2018 090 952

## Description

### Field of the Invention

The invention relates to a battery module, particularly to a battery module comprising a cell supervision circuit, CSC, with a flexible circuit board, FCB, connected to the battery cells.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for electronic devices, such as cellular phones, notebooks and camcorders, while high-capacity rechargeable batteries are used as power supply for hybrid vehicles or the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose.

Rechargeable batteries may be used as a battery module formed of a plurality of unit battery cells coupled in series and/or in parallel so as to provide a high energy density, e.g. for motor driving of a hybrid vehicle. That is, the battery module is formed by interconnecting the electrode terminals of the plurality of unit battery cells depending on a required amount of power and in order to realize a high-power rechargeable battery, e.g. for an electric vehicle.

Battery modules can be constructed either in block design or in modular design. In block designs, each battery cell is coupled to a common current collector structure and a common battery management system. In modular designs, pluralities of battery cells are connected to form submodules and several submodules are connected to form the battery module. Battery management functions may be realized either on module or submodule level and thus interchangeability of the components is improved. One or more battery modules are mechanically and electrically integrated, equipped with a thermal management system and set up for communication with electrical consumers in order to form a battery system.

To provide thermal control of a battery system a thermal management system is required to safely use the at least one battery module by efficiently emitting, discharging and/or dissipating heat generated from its rechargeable batteries. If the heat emission/discharge/dissipation is not sufficiently performed, temperature deviations occur between respective battery cells, such that the at least one battery module cannot generate a desired amount of power. In addition, an increase of the internal temperature can lead to abnormal reactions occurring therein and thus charging and discharging performance of the rechargeable deteriorates and the life-span of the rechargeable battery is shortened. Thus, cooling devices for effectively emitting/discharging/dissipating heat from the cells is required.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers. Battery systems usually comprise a battery management system (BMS) for processing this information.

The BMS is usually coupled to the controller of one or more electrical consumers as well as to each of the battery modules of the battery system. For controlling a plurality of battery modules by a single BMS a daisy chain setup may be used. In such setup, the BMS, as master, is connected for communication in series to a plurality of battery modules, particularly to a plurality of cell supervision circuits, CSC, of the respective battery modules. Therein, the BMS is configured to receive and process information of each of the CSCs as well as of external consumer or control units, e.g. a vehicle board net, connected thereto. Further, each of the CSCs is configured to detect voltages and/or temperatures of an individual battery module and to communicate the detected voltages and/or temperatures to the BMS. The CSCs may be further configured for cell balancing within the battery modules.

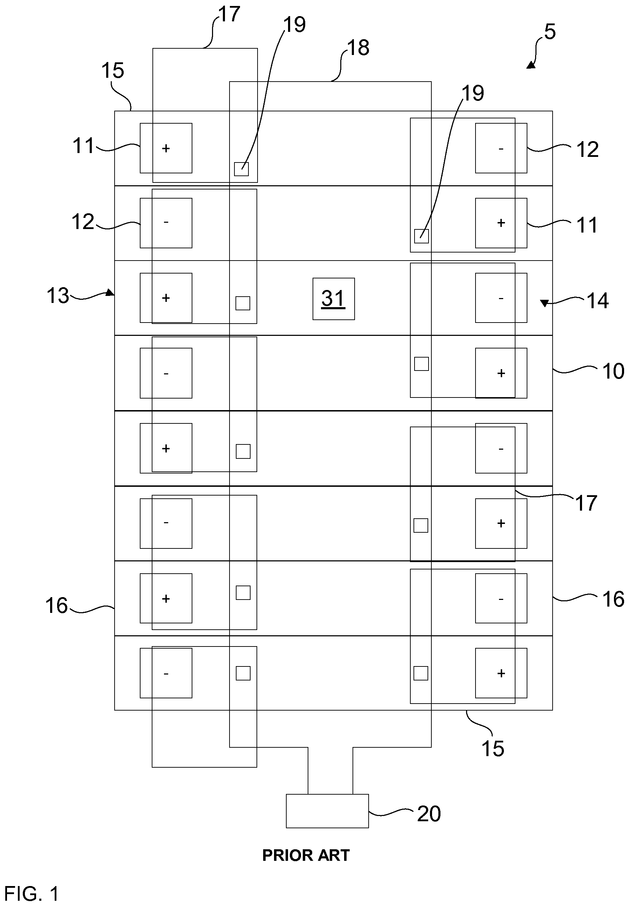

In a battery module 5 according to the prior art as shown exemplarily in Figure 1, a plurality of prismatic battery cells 10 are stacked together. Each battery cell 10 has a cell case 13 with essentially rectangular cross section having a pair of opposite wide side surfaces 15 and a pair of opposite narrow side surfaces 16 that are perpendicular to the wide side surfaces 15. Further, each battery cell 10 has a cap assembly 14 covering the cell case 13 and having a rectangular shape with a pair of opposite wide sides and a pair of opposite narrow sides that are perpendicular to the wide sides. In battery module 5, the battery cells 10 are aligned such that wide side surfaces 15 of adjacent battery cells 10 face each other.

Each of the battery cells 10 comprises a positive cell terminal 11 near a first narrow side of the cap assembly 14 and a negative cell terminal 12 near an opposite second narrow side of the cap assembly 14. The battery module 5 shown in Figure 1 has a 1p8s configuration, i.e., comprises eight battery cells 10 connected in series and no battery cells connected in parallel within the battery module 5. In the battery module 5 of Figure 1, the terminals of adjacent battery cells 10 are of opposite polarity and are connected to each other via a respective busbar 17. However, in a battery module having a XpYs configuration, X battery cells 10 are connected in parallel within the battery module, bundles of X parallely connected cells are connected in series via respective busbars, and the terminals of such adjacent battery cell bundles, each comprising X battery cells, are of opposite polarity (not shown). Busbars following each other along the current path of the battery module 5 are usually disposed on different sides of the battery module, i.e. near opposite narrow side surfaces 16.

The battery module 5 as shown in Figure 1 further comprises a cell supervision circuit carrier, CSCC, 18, i.e., a substrate that is at least configured for receiving a CSC 31 or comprises or even constitutes a CSC 31. The CSCC 18 also includes a connector 20 for establishing a data communication with the CSC 31. In order to enable the CSC 31 to work properly, it needs to receive cell voltages and/or temperatures of the plurality of battery cells 10. Therefore, an electric and/or thermal connection has to be established between the CSC 31 and the plurality of battery cells 10 via the CSCC 18. Such connection may be established by wire or weld connections, whereas weld connections are more stable and provide good signal transmission. For receiving cell voltages of the cells 10 via weld connections (or weld pads) 19, the CSCC 18 overlaps with the busbars 17 or even with the terminals 11, 12 of the battery module 5 and has thus to span in the width direction of the battery module 5 at least for the distance between busbars 17 that follow each other along the current path of the module 5 or even for the distance between the terminals 11, 12 of a cell 10, i.e. nearly for the width of a cell 10.

A CSCC 18 of the prior art that is connected to a plurality of terminals 11, 12 or busbars 17 of a battery module 5 has thus to extend along the whole length and nearly the whole width of the battery module 5 and is therefore material-consuming. Even if the CSCC 18 is further shaped at a later stage an amount of used substrate material depends on the raw panel size.

Circuits with supervising functions to a battery module are known from the prior art, e.g., from EP 3063824 A1, US 2017/133724 A1, CN 207233847 U, and US 2018/090952 A1.

It is thus an object of the present invention to overcome or reduce at least some of the drawbacks of the prior art and to provide a battery module with cell supervision circuit carrier that allows for reducing the substrate material and hence the costs of the battery module.

### Summary of Invention

One or more of the drawbacks of the prior art could be avoided or at least reduced by means of the present invention. In particular, a battery module is provided that comprises a plurality of aligned battery cells, i.e., a plurality of battery cells that are stacked in a lengthwise direction of the battery module. According to an embodiment, the battery module comprises a plurality of stacked prismatic battery cells. Each of the battery cells further comprises a cell case and a cap assembly placed on the cell case for closing the cell case. According to an embodiment, the battery cell comprises an electrode assembly, a negative cell terminal and a positive cell terminal. The positive cell terminals of the battery cells are either constituted by or at least connected to the cell case of the respective battery cell of the battery module.

The battery module further comprises a plurality of busbars that are disposed on top of the cap assemblies of the battery cells, i.e., above the cap assemblies. Each of the busbars is configured for electrically connecting the cell terminals of at least two battery cells. However, the amount of battery cells connected via one busbar depends on the number of battery cells connected in parallel within the battery module. Together, the plurality of busbars is configured to transport the electric current of the battery module, e.g., to external consumers.

The battery module further comprises a cell supervision circuit carrier, CSCC which is configured to host a cell supervision circuit, CSC or is even hosting a CSC. Therein, a CSC refers to a microprocessor, ASIC, or any (integrated) circuit that is configured to receive signals corresponding to the voltage and/or temperature of at least one battery cell of the module. Preferably, the CSC is further configured to process, analyze and/or store the received signals and the CSC may be further configured to transmit signals related to the received signals to another CSC and/or a BMS. Further preferred, the CSC may be configured to perform at least one control function with respect to the battery module or with respect to at least one battery cells thereof. Therein the control functions may comprise measurements or determinations of cell voltages, cell currents, cell resistances or cell capacities and may further comprise the active or passive balancing of cell voltages or cell currents of battery cells on the battery module.

In other words, the CSCC is a substrate that is configured for receiving the CSC thereon or therein, e.g., by providing a suitable chip socket, landing pads or wire frame for a CSC or that is at least configured for being connected to the CSC. The CSCC further comprises a connector that is configured for establishing a data communication with the CSC. According to first embodiment, wherein the CSC is received on or in the CSCC, the connector preferably establishes a data communication between the CSC received on or in the CSCC and another CSC and/or a BMS or an external control unit, e.g. a control unit of an external consumer. According to a second embodiment, the CSC is connected to the CSCC via the connector itself, i.e., the CSC is not disposed on or in the CSCC but is external to the CSCC substrate but is data connected, and preferably power connected, to the CSCC via the connector. Then, the CSC may be further configured to communicate with another CSC and/or a BMS via the connector or another signaling port.

Advantageously, a battery system with a plurality of battery modules according to the present invention, each comprising a cell supervision circuit carrier, can be set up for a daisy chain communication with a BMS. Preferable, the cell supervision circuits are configured to transmit and receive digital or analogous signals, e.g. differential signals, via the connectors or via another signaling port connecting the CSCs to each other and/or to a BMS. The signals may be modulated on alternating currents. As this kind of communication is less dependent of the voltage levels of the individual battery modules it is less error-prone and thus secure communication can be provided even between unbalanced battery modules.

According to the present invention, the CSCC is configured to electrically connect the CSC to the negative cell terminal of one battery cell, wherein the one battery cell preferably is one of the plurality of battery cells of the battery module but may also be one battery cell of another battery module, preferably another battery module of the same battery system. The latter case is described in more detail below with respect to a battery system. The CSCC of the invention is further configured to electrically connect the CSC to the cell cases of at least some of the remaining battery cells of the plurality of battery cells. Therein, the CSC is able to receive signals corresponding to the voltage of each battery cell connected thereto via the CSCC, and preferably also via the connector being a part of the CSCC. Preferably, the CSCC is electrically connected to the negative cell terminal of one of the plurality of battery cells and to the cell cases of at least some of the remaining battery cells of the plurality of battery cells. By connecting the CSC, via the CSCC, to the cell cases of most of the battery cells instead of to the terminals of these battery cells or to busbars connected to these terminals, the area of the CSCC can be significantly reduced.

According to a preferred embodiment of the battery module, the plurality of aligned battery cells comprises a plurality of subsets of battery cells, wherein each subset of battery cells consists of battery cells connected in parallel and wherein the subsets of battery cells are connected in series within the battery module. In this embodiment, the CSCC is configured to electrically connect the CSC to the negative cell terminal of at least one, preferably each, battery cell of one subset of battery cells and to the cell case(s) of at least one, preferably each, battery cell of at least some, preferably each, remaining subsets of battery cells. In this embodiment, the CSC is able to receive signals corresponding to the voltage of each battery subset connected thereto via the CSCC. Preferably, the CSCC is electrically connected to the cell case of at least one battery cell of each subset of battery cells. Then, the CSC is able to receive signals corresponding to the voltage of each battery subset of the module. Particularly preferred, the CSCC is configured to connect the CSC to the cell cases of each of the remaining battery cells. Then, the CSC is able to receive signals corresponding to the voltage of each battery cell (of each battery subset) of the battery module.

In a particularly preferred embodiment, a plurality of weld pads is disposed on an underside of the CSCC, at least in a state where the CSCC is electrically connected to battery cells of the battery module as described above. The weld pads may be preconfigured on an underside of the CSCC and may be further configured to facilitate an electric and preferably mechanic connection, e.g., a weld connection, between the CSCC and a battery cell terminal, busbar, or cell case, respectively. Alternatively, the weld pads may be formed on an underside of the CSCC during a process of electrically and or mechanically connecting the CSCC to battery cell terminals, busbar, or cell cases of the battery module, e.g. by welding. The weld pads may be configured for facilitating or may be formed during laser welding or an ultrasonic welding process. Alternatively, the weld pads may be configured to facilitate solder connections or even wire connections. Particularly preferred, a first weld pad is connected to a negative terminal of a battery cell of the battery module, preferably of an outermost battery cell of the battery module, and the remaining weld pads are individually connected to the cell cases of the remaining battery cells of the module. Further, each of the weld pads is configured for tapping cell voltages of the battery cell to which it is connected, i.e., to provide an ohmic connection to the terminal or the case of the battery cell.

In a further preferred embodiment, the CSCC is configured to receive the CSC on a top side thereof. Particularly, the CSC is actually disposed on a top side of the CSCC, e.g., is surface mounted to the top side of the CSCC. Further preferred, the CSC mounted to the CSCC is electrically connected to each of the weld pads described above. As each of the weld pads provides an ohmic connection to a battery cell of the battery module, the CSC is electrically connected to each of these cells. The electrical connections between the CSC and the weld pads are preferably at least partially provided by conductive lines, i.e., by planar conductive structures on and/or along a surface of the CSCC. The conductive lines may be formed by surface metallizations, conductive inks, or the like. The electrical connections between the CSC and the weld pads are further preferred at least partially provided by through holes vias extending from a top side to a lower side of the CSCC and through the material of the CSCC.

According to another preferred embodiment, a temperature sensor is disposed on a top side of the CSCC and overlaps with at least one of the weld pads on an underside of the CSCC. Therein, the at least one weld pad provides a good thermal connection between the battery cell (terminal or case) it is connected to and the temperature senor, while the CSCC in between the weld pad and the CSCC preferably provides an electric insulation between the weld pad and the CSCC. Particularly preferred, the temperature sensor is a thermistor-based temperature sensor, e.g., a NTC sensor. Such sensor preferably comprises a temperature-dependent resistance connecting two conductive pads, e.g., copper metallizations, wherein each conductive pad is further connected to a measurement circuit for receiving a probe signal. Then, the contact pads are disposed in the projected area of the corresponding weld pad, i.e., a metallization of the same dimension as the combined conductive pads is disposed on an underside of the CSCC. The overlapping conductive pads on the top side and the underside of the CSCC increase the thermal connectivity from cell to sensor.

According to a further preferred embodiment, one of the busbars comprises a protrusion overlapping with the CSCC and the remaining busbars are not overlapping the CSCC. Particularly preferred, the remaining busbars are preferably made of an electrically conductive material, e.g. aluminum, and have a strip-like shape with a substantially uniform busbar width and a uniform busbar height. Then, the one busbar is of similar constitution but comprises a protrusion extending therefrom in a direction dissimilar, e.g., perpendicular, to an extension direction of the busbar between two connected terminals. However, such protrusion can be combined with other busbar shapes, e.g., curved busbar shapes, as well. Particularly, the shape of the busbars may be freely adapted to meet individual requirements of a specific battery design, e.g. in view of a limited installation space. In particular, the busbar can be in the form of straight, bend or arbitrary curved belts, bands, ribbons, ribs or rails. This embodiment advantageously allows to use and to dispose a strip-shaped CSCC next to the remaining busbars for easy connection to the cell cases with one weld pad connecting the CSCC to the busbar protrusion for realizing the CSCC's electric connection to the electric terminal of one battery cell, preferably an outermost battery cell, of the module. The busbars with the protrusion is thus preferably an outermost busbar of the battery module that is connected to an outermost battery cell of the battery module.

Particularly preferred, the CSCC is formed of a flexible circuit board, FCB, i.e., of a flexible substrate as commonly used for flexible printed circuits, such as e.g., polyimide, PEEK or transparent conductive polyester film. Any conducting surface structures as described above, i.e., weld pads or conductive lines, may be printed, e.g., screen-printed, to the substrate. Particularly preferred, the CSCC of this embodiment or of any other embodiment described herein extends along a length direction of the battery module, preferably along the whole length of the battery module in the stacking direction of the battery cells. Further preferred, the CSCC of this embodiment or of any other embodiment described herein has a width, i.e., a spatial extension in a width direction of the battery module perpendicular to the stacking direction of the battery module, which is less than the distance between adjacent busbars, particularly adjacent busbars following each other along the current path of the battery module. Additionally or alternatively, the CSCC of this embodiment or of any other embodiment described herein has a width that is less than the distance between terminals of a cell and thus, for most battery cells, is significantly less than the width of the battery cell. Again, the CSCC of the present invention allows minimizing its material costs significantly.

In a particularly preferred embodiment, the cell supervision circuit carrier comprises a flexible circuit board as described above, the flexible circuit board comprising a first lateral edge and a second lateral edge that is opposite to the first lateral edge. In other words, the flexible circuit board has an essential rectangular shape that is preferably adapted to the dimensions of an essential rectangular battery module to which the flexible circuit board is mounted. There, the connector is preferably arranged at a first lateral edge of the flexible circuit board.

Preferably, the FCB (CSCC) comprises at least one curved section between adjacent weld pads. In other words, the FCB is not completely strip-shaped but comprises a curvature in any spatial direction that is disposed in between two weld pads. Hence, the FCB does not connect the weld pads along a shortest distance there between and a material reservoir of the FCB is formed between the weld pads. Such material reservoir allows the FCB to compensate for cell swelling or otherwise caused spatial displacements of the battery cells forming the battery module. Hence, by a minor amendment of the CSCC, the battery module allows to provide sufficient electric contact between the CSC and the battery cells even in the case of cell swelling or spatial displacement of battery cells. Preferably, the curved section of the FCB in between two weld pads is curved in a height direction of the battery module.

Another aspect of the present invention is directed to a battery system comprising a plurality of battery modules according to the present invention as described above, wherein the battery modules are set up in communication with a BMS and/or with each other. Further preferred, the battery system comprises a plurality of identical battery modules, each comprising the same amount of battery cells that are stacked in the same way. Further preferred, the battery system comprises a plurality of identical cell supervision circuit carriers, each being adapted to the size and the shape of the battery modules. Particularly preferred, each of the cell supervision circuit carriers comprises a flexible circuit board with an essential rectangular shape and a first lateral edge and a second lateral edge that is opposite to the first lateral edge. Further, each circuit carrier board comprises a connector that is arranged at a lateral edge. Hence, interchangeability of the system's components, e.g., in a daisy chain setup with a BMS, is increased while the amount of required spare parts is decreased.

According to a preferred embodiment, the battery system comprises at least two battery modules, i.e., at least one first battery module and at least one a second battery module, each of which comprises a plurality of aligned battery cells, wherein each of the battery cells comprises a cell case, a cap assembly placed on the cell case, a negative cell terminal and a positive cell terminal, and a plurality of busbars disposed on top of the cap assemblies, wherein each of the busbars is configured for electrically connecting cell terminals of at least two battery cells. Therein, each battery modules comprises a cell supervision circuit carrier, CSCC, which is configured to host a cell supervision circuit, CSC, and which comprises a connector that is configured for establishing a data communication with the CSC. Therein, the CSCC of at least one first battery module is configured to electrically connect the CSC to the negative cell terminal of one battery cell of the second battery module and to the cell cases of at least some of the remaining battery cells of the first battery module. In other words, the one terminal voltage required for the CSC of a first battery module to function correctly can be also tapped from a terminal or busbar of a second battery module.

Another aspect of the present invention is directed to a method for assembling a CSCC as described above, i.e. a CSCC that is configured to host a cell supervision circuit, CSC, and to comprise a connector configured for establishing a data communication with the CSC, to a battery module, particularly to a battery module as described above, i.e., comprising a plurality of aligned battery cells, wherein each of the battery cells comprises a cell case, a cap assembly placed on the cell case, a negative cell terminal and a positive cell terminal. The method of the invention comprises at least the steps of: fixating the CSCC to the underside of a vacuum tool by applying an under pressure to the CSCC via the vacuum tool, positioning the fixated CSCC over the battery module via the vacuum tool, and electrically connecting the CSCC to the negative cell terminal of one battery cell, preferably to the negative cell terminal of one battery cell of the plurality of battery cells, and to the cell cases of at least some, preferably each, of the remaining battery cells of the plurality of battery cells. Therein, the vacuum tool preferably comprises an underside that is fitted to a size of the CSCC and at least one suction hole for providing the under pressure for fixating the CSCC to the underside of the vacuum tool and to lift the CSCC.

In a preferred embodiment of the method, the vacuum tool comprises a plurality of welding through holes that extend from an upper side of the vacuum tool to a lower side of the vacuum tool. Thus, an apparatus for connecting the CSCC to the battery cell terminal and/or the cell cases, e.g. a welding apparatus, can advantageously be guided through the vacuum tool and thus the connection (welding) process can be easily performed. Further preferred, the lower side of the vacuum tool further comprises at least one curved portion that is disposed between adjacent welding through holes, particularly a curved portion with a curvature in the height direction of the battery module, i.e., in a direction towards the upper side of the vacuum tool. These curved portions advantageously allow for fixating a CSCC to the battery module via a plurality of weld pads with curved portions between adjacent well pads. Hence, this embodiment allows for a battery module that can compensate cell swelling. Therefore, the CSCC is preferably weld connected to a negative terminal of an outermost battery cell and to the cell cases of the remaining battery cells of the battery module, wherein at least one curved portion of the CSCC is formed between adjacent weld pads.

Another aspect of the present invention relates to an electric vehicle that comprises a battery module, preferably a plurality of battery modules, of the invention as described above and/or a battery system as described above. Further aspects of the present invention are disclosed in the dependent claims, the appended drawing and in the following description thereof.

### Brief Description of the Drawings

Features will become apparent to those of ordinary skill in the art by describing in detail exemplary embodiments with reference to the attached drawings in which:
- Fig. 1: illustrates a schematic top view of a battery module according to the prior art;
- Fig. 2: illustrates a schematic top view of a battery module according to an embodiment;
- Fig. 3: illustrates a schematic top view of a battery module according to an alternative embodiment;
- Fig. 4: illustrates a schematic side view of a battery module according to an embodiment;
- Fig. 5: illustrates a schematic top view of a temperature sensor mounted to a battery module according to an embodiment; and
- Fig. 6: illustrates (A) a schematic side view and (B) a schematic top view of a CSCC fixated to a mounting tool during a method according to an embodiment.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Processes, elements, and techniques not considered necessary to those having ordinary skill in the art for a complete understanding of the aspects and features of the present invention may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present invention refers to "one or more embodiments of the present invention." In the following description of embodiments of the present invention, the terms of a singular form may include plural forms unless the context clearly indicates otherwise. As used herein, the term "and/or" includes any and all combinations of one or more of the associated listed items. Expressions such as "at least one of," when preceding a list of elements, modify the entire list of elements and do not modify the individual elements of the list.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention. As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value.

The battery system according to the prior art as illustrated in Figure 1 has already been described in the introductory part of the present application. As already mentioned there, the CSCC 18 according to the prior art extends, at least in an initial state, in a width direction for more than the distance between adjacent busbars 17, i.e., to overlap with the busbars 17 along both sides of the battery module 5. Hence, material costs for CSCC substrate are high.

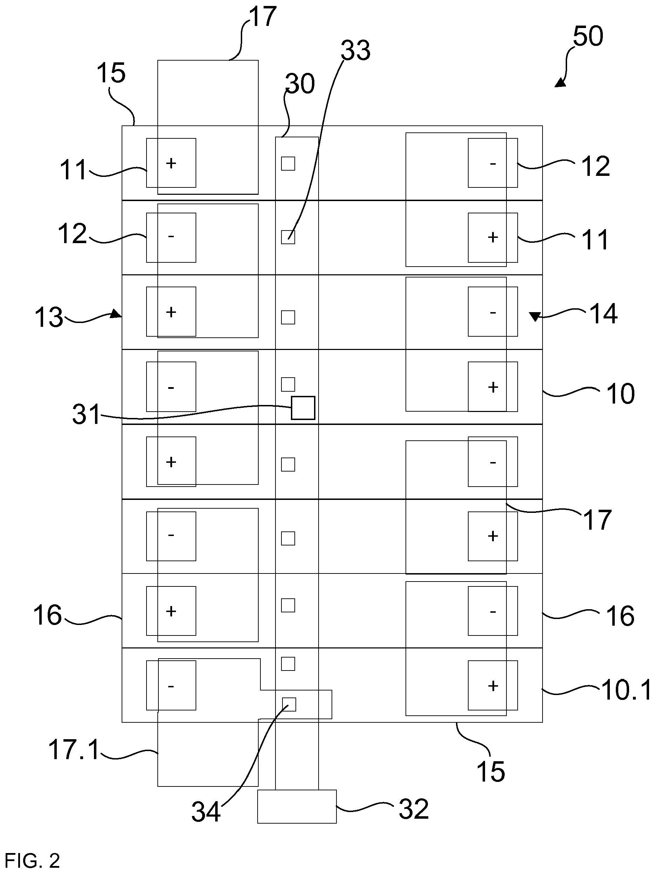

Figure 2 illustrates a schematic top view of a battery module 50 according to an embodiment. Therein, the battery module 50 is formed of a battery cells 10 connected in series and thus has an 8s1p configuration. Therein, the battery module 50 of Figure 2 is identical to the battery module 5 of the prior art and further the busbar configuration is similar to the configuration of the busbars 17 of the prior art battery module 5. Solely a busbar 17.1 that is electrically connected to a negative cell terminal 12 of an outermost battery cell 10.1 differs from the corresponding busbar 17 of the prior art battery module 5. Particularly, the busbar 17.1 of battery module 50 comprises a protrusion extending from the busbar 17.1 in a direction perpendicular to the direction between cell terminals 11, 12 of adjacent cells 10.

The shape of busbar 17.1 allows to electrically connect the cell supervision circuit carrier, CSCC 30 according to an embodiment to the negative cell terminal 12 of the outermost battery cell 10 via a first weld pad 34 disposed on an underside of the CSCC 30. Above that, the CSCC 30 is connected to the cell case 13 of each of the remaining battery cell 10 of the battery module 50 via a respective weld pad 33. Hence, a voltage (e.g. a positive voltage) signal of each battery cell 10 relative to the voltage ground potential of the negative cell terminal 12 of the outermost battery cell 10.1 can be provided to a cell supervision circuit, CSC 31 disposed on the CSCC 30. Therein, the CSCC 30 must not overlap with the busbars 17 on both sides of the battery module 50 and is thus formed of a thin stripe flexible circuit board that is disposed next to the busbars 17 above the cap assemblies 14 of the aligned battery cells 10. The CSCC 30 of the present invention has thus a drastically decreased surface area, even in an initial state of the raw flexible circuit board, and hence allows for reducing material costs. Further, a connection with the CSC 31 and other CSCs or a BMS is provided via connector 32 of CSCC 30.

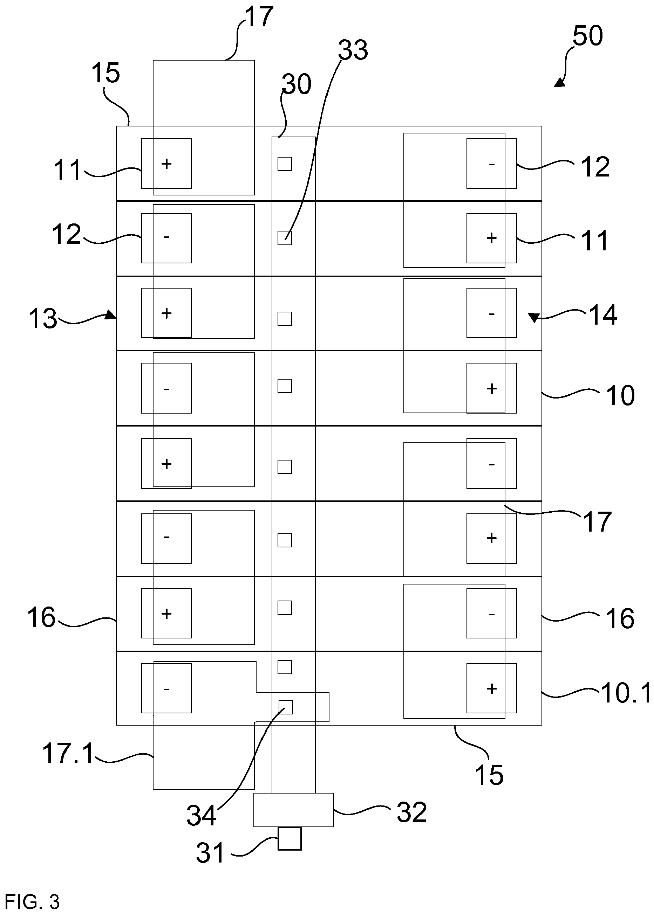

Figure 3 illustrates a schematic top view of a battery module 50 according to an alternative embodiment. The embodiment of Figure 3 is not described insofar it is identical to the battery module 50 as illustrated in Figure 2. However, according to Figure 3, a CSC 31 is not disposed on the CSCC 30 but rather is connected to the CSCC 30 via the connector 32. In other words, the CSC 31 is separate of the CSCC and data connected, and preferably power connected, to the CSCC 30 via the connector 32. Still, the CSC 31 is connected to the battery cells 10 of the battery module 50 via the CSCC 30 comprising the connector 32. According to this embodiment, the function of the connector 32 may thus differ from the function of the connector 32 illustrated in Figure 2. However, also in the embodiment of Figure 3, the connector 32 may connect the CSC 31 to other CSCs 31 or to a BMS, e.g. via a daisy chain. Also, the CSC 31 may comprise an additional signal port for such a connection.

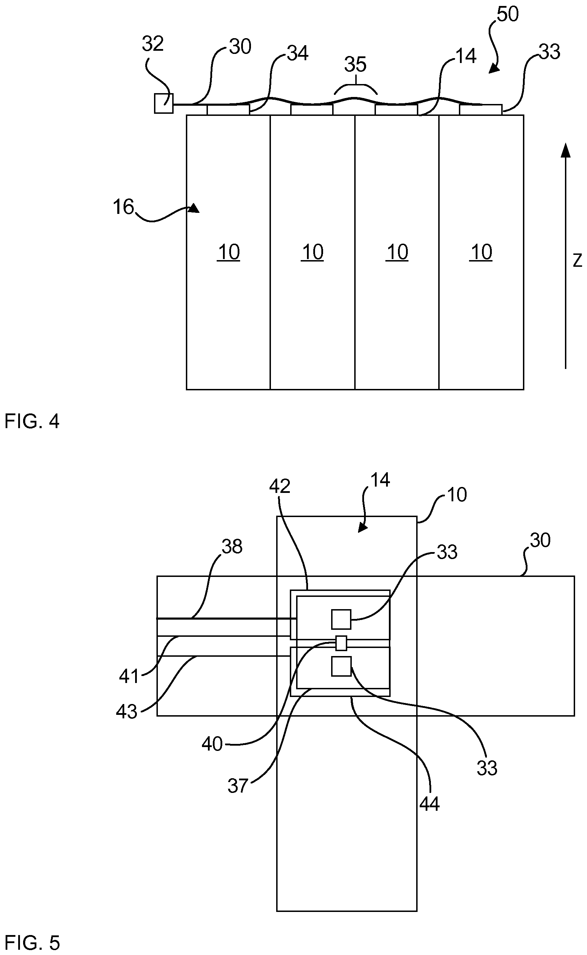

A schematic side view of the battery module 50 according to an embodiment is illustrated in Figure 4. As shown there, the CSCC 30 is connected to each battery cell 10 via a respective weld pad 33, 34 disposed on an underside of the CSCC 30. The CSCC 30 terminates in one end in the connector 32 that is configured to connect the CSC 31 as shown in Figure 2 to the CSC of another battery module or to a BMS. As illustrated in Figure 4, the CSCC 30 comprises a plurality of curved sections 35, wherein each curved section 35 is positioned between adjacent weld pads 33, 34. Therein, each curved section 35 is curved in a positive Z-direction, i.e., the height direction of the battery module 50. Thus, material reservoirs of the CSCC 30 are formed between adjacent weld pads 33, 34 and thus the CSCC 30 can compensate cell swelling of the battery cells 10 and the module 50 is more long-term stable.

Figure 5 illustrates a schematic top view of a temperature sensor 40 mounted to the battery module 50 according to an embodiment. Therein, the temperature sensor 40, i.e., a NTC thermistor 40 is mounted to a top side of a CSCC 30 disposed over a cap assembly 14 of a battery cell 10 of the battery module 50. The NTC thermistor 40 electrically connects to a first conductive pad 42 and to a second conductive pad 44 that provide the probe voltage to the NTC thermistor 40 and are therefore connected to a voltage source (not shown) via a first and second conductive line 41, 43 formed on the top side of the CSCC 30, respectively. On the lower side of the CSCC 30 two weld pads 33 as described above are disposed for connecting the CSCC 30 to the cap assembly 14 of the battery cell 10. Around the weld pads 33 a bottom metallization 37 is formed on the lower side of the CSCC 30 that is of the same dimension as the combination of the first and second conductive pads, 42, 44, i.e., overlaps with both of the conductive pads 42, 44. Hence, an improved thermal connection is provided between the cap assembly 14 of the battery cell 10 and the NTC thermistor 40 and thus temperature measurements via the NTC thermistor 40 are improved. The battery module 50 of an embodiment preferably comprises at least one such temperature sensor 40.

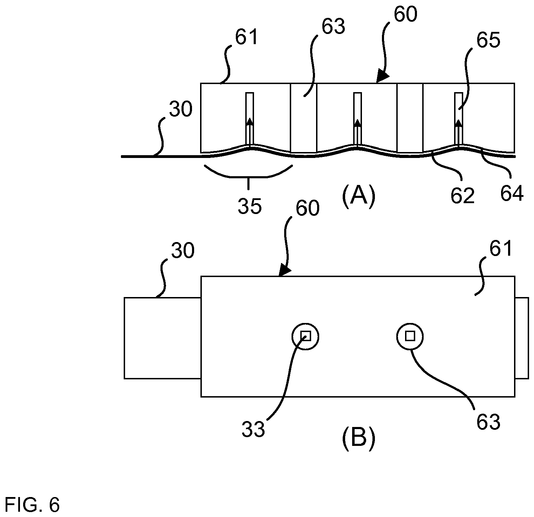

A method for assembling a CSCC 30 to a battery module 50 according to an embodiment is illustrated in Figure 6 in (A) a schematic side view and (B) a schematic top view of the CSCC 30 fixated to a vacuum tool 60. Therein, the vacuum tool 60 comprises a plurality of suction holes 65 each of which is configured to provide an under pressure to an upper side of the CSCC 30 for fixating the CSCC 30 to a lower side 62 of the vacuum tool 60. Therein, the lower side 62 of the vacuum tool 60 comprises a plurality of curved portions 64 that are curved in a positive Z-direction of a battery module (not shown), i.e., towards the upper side 61 of the vacuum tool 60. Hence, by sucking the flexible CSCC 30 to the lower side 62 of the vacuum tool 60 via the suction holes 65, the curved sections 35 are formed in the CSCC 30.

The vacuum tool 60 further comprises a plurality of welding through holes 63 that extend from an upper side 61 of the vacuum tool 60 to the lower side 64 thereof. Hence, a welding assembly (not shown) can be guided through the welding through holes 63 for connecting the CSCC 30 disposed below vacuum tool 60 to a battery cell via a respective weld pad 33.

### Reference signs

- 5: battery module (prior art)
- 10: battery cell
- 10.1: outermost battery cell
- 11: positive terminal
- 12: negative terminal
- 13: cell case
- 14: cap assembly
- 15: wide side surface
- 16: narrow side surface
- 17: busbar
- 17.1: busbar with protrusion
- 18: cell supervision circuit carrier (prior art)
- 19: weld pad (prior art)
- 20: connector (prior art)
- 30: cell supervision circuit carrier
- 31: cell supervision circuit
- 32: connector
- 33: weld pad
- 34: first weld pad
- 35: curved section
- 37: bottom metallization
- 38: conductive line
- 40: temperature sensor
- 41: first conductive line
- 42: first conductive pad
- 43: second conductive line
- 44: second conductive pad
- 50: battery module
- 60: vacuum tool
- 61: upper side
- 62: lower side
- 63: welding hole
- 64: curved portion
- 65: suction hole

## Claims

1. Battery module (50), comprising:
a plurality of aligned battery cells (10), each of the battery cells (10) comprising a cell case (13), a cap assembly (14) placed on the cell case (13), a negative cell terminal (11) and a positive cell terminal (12);
a plurality of busbars (17) disposed on top of the cap assemblies (14), each of the busbars (17) being configured for electrically connecting cell terminals (11, 12) of at least two battery cells (10);
a cell supervision circuit carrier, CSCC, (30) configured to host a cell supervision circuit, CSC, (31) and comprising a connector (32) configured for establishing a data communication with the CSC (31),
wherein the CSCC (30) is configured to electrically connect the CSC (31) to the negative cell terminal (12) of one battery cell (10) and to the cell cases (13) of at least some of the remaining battery cells (10) of the plurality of battery cells (10), the cell cases (13) constituting or being connected to the positive terminals (12).

2. Battery module (50) according to claim 1, wherein the plurality of aligned battery cells (10) comprises a plurality of subsets of parallely connected battery cells (10), the subsets of battery cells (10) being connected in series, and wherein the CSCC (30) is configured to electrically connect the CSC (31) to the negative cell terminal (12) of a battery cell (10) of one subset of battery cells (10) and to the cell case (13) of at least one battery cell (10) of at least some remaining subsets of battery cells (10).

3. Battery module (50) according to claim 1 or 2, wherein the CSCC (30) is configured to connect the CSC (31) to the cell cases (13) of each of the remaining battery cells (10).

4. Battery module (50) according to any one of the preceding claims, wherein a plurality of weld pads (33, 34) is disposed on an underside of the CSCC (30), wherein a first weld pad (34) is connected to a negative terminal (11) of an outermost battery cell (10.1) and the remaining weld pads (33) are individually connected to the cell cases (13) of the remaining battery cells (10).

5. Battery module (50) according to claim 4, wherein the CSC (31) is disposed on a top side of the CSCC (30) and is electrically connected to each of the weld pads (33, 34).

6. Battery module (50) according to claim 5, wherein the electric connections between the CSC (31) and the weld pads (33, 34) are at least partially provided by conductive lines and/or through holes vias.

7. Battery module (50) according to any one of the claims 4 to 6, wherein a temperature sensor (40) is disposed on a top side of the CSCC (30) and overlaps with at least one of the weld pads (33, 34) or a metallization around at least one weld pads (33, 34).

8. Battery module (50) according to any one of the preceding claims, wherein one of the busbars (17.1) comprises a protrusion overlapping with the CSCC (30) and wherein the remaining busbars (17) are disposed next to the CSCC (30).

9. Battery module (50) according to any one of the preceding claims, wherein the CSCC is formed of a flexible circuit board, FCB, (30) extending along a length direction of the battery module (50) with a width less than the distance between adjacent busbars (17) and/or less than the distance between terminals (11, 12) of a battery cell (10).

10. Battery module (50) according to claims 4 and 9, wherein the FCB (30) comprises at least one curved section (35) between adjacent weld pads (33, 34).

11. Battery module (50) according to claim 10, wherein the curved section (35) is curved in a height direction (Z) of the battery module (50).

12. Method of assembling a cell supervision circuit carrier, CSCC (30), configured to host a cell supervision circuit, CSC, (31) and to comprise a connector (32) configured for establishing a data communication with the CSC (31), to a battery module (50), comprising a plurality of aligned battery cells (10), each of the battery cells (10) comprising a cell case (13), a cap assembly (14) placed on the cell case (13), a negative cell terminal (12) and a positive cell terminal (11), the method comprising the steps of:
fixating the CSCC (30) to the underside of a vacuum tool (60) by applying an under pressure to the CSCC (30) via the vacuum tool (60),
positioning the fixated CSCC (30) over the battery module (50) via vacuum tool (60), and
electrically connecting the CSCC (30) to the negative cell terminal (12) of one battery cell (10) and to the cell cases (13) of at least some of the remaining battery cells (10) of the plurality of battery cells (10), the cell cases (13) constituting or being connected to the positive terminals (12).

13. Method of claim 12, wherein the vacuum tool (60) comprises a plurality of welding through holes (63) extending from an upper side (61) to a lower side (62) of the vacuum tool (60) and/or wherein the lower side (62) of the vacuum tool (60) comprises at least one curved portion (64) disposed between adjacent welding through holes (63).

14. Method of claim 12 or 13, wherein the CSCC (30) is weld connected to a negative terminal (12) of an outermost battery cell (11.1) and to the cell cases (13) of the remaining battery cells (10), wherein at least one curved section (35) of the CSCC (30) is formed between adjacent weld pads (33, 34).

## Patentansprüche

1. Batteriemodul (50), das umfasst:
eine Vielzahl aneinandergereihter Batteriezellen (10), wobei jede der Batteriezellen (10) ein Zellengehäuse (13), eine Kappenanordnung (14), die auf dem Zellengehäuse (13) platziert ist, eine negative Zellenklemme (11) und eine positive Zellenklemme (12) umfasst;
eine Vielzahl von Sammelschienen (17), die auf der Oberseite der Kappenanordnungen (14) angeordnet ist, wobei jede der Sammelschienen (17) dazu konfiguriert ist, die Zellenklemmen (11, 12) von mindestens zwei Batteriezellen (10) elektrisch zu verbinden;
einen Zellenüberwachungsschaltungsträger, CSCC, (30), der dazu konfiguriert ist, eine Zellenüberwachungsschaltung, CSC, (31) unterzubringen und der einen Steckverbinder (32) umfasst, der dazu konfiguriert ist, eine Datenkommunikation mit der CSC (31) herzustellen,
wobei der CSCC (30) dazu konfiguriert ist, die CSC (31) elektrisch mit der negativen Zellenklemme (12) einer Batteriezelle (10) und mit den Zellengehäusen (13) mindestens einiger der restlichen Batteriezellen (10) der Vielzahl von Batteriezellen (10) zu verbinden, wobei die Zellengehäuse (13) die positiven Klemmen (12) bilden oder damit verbunden sind.

2. Batteriemodul (50) nach Anspruch 1, wobei die Vielzahl aneinandergereihter Batteriezellen (10) eine Vielzahl von Subsätzen parallel geschalteter Batteriezellen (10) umfasst, wobei die Subsätze von Batteriezellen (10) in Reihe geschaltet sind, und wobei der CSCC (30) dazu konfiguriert ist, die CSC (31) elektrisch mit der negativen Zellenklemme (12) einer Batteriezelle (10) eines Subsatzes von Batteriezellen (10) und mit dem Zellengehäuse (13) mindestens einer Batteriezelle (10) mindestens einiger restlicher Subsätze von Batteriezellen (10) zu verbinden.

3. Batteriemodul (50) nach Anspruch 1 oder 2, wobei der CSCC (30) dazu konfiguriert ist, die CSC (31) mit den Zellengehäusen (13) jeder der restlichen Batteriezellen (10) zu verbinden.

4. Batteriemodul (50) nach einem der vorstehenden Ansprüche, wobei eine Vielzahl von Schweißstücken (33, 34) auf einer Unterseite des CSCC (30) angeordnet ist, und wobei ein erstes Schweißstück (34) mit einer negativen Klemme (11) einer äußersten Batteriezelle (10.1) verbunden ist, und die restlichen Schweißstücke (33) individuell mit den Zellengehäusen (13) der restlichen Batteriezellen (10) verbunden sind.

5. Batteriemodul (50) nach Anspruch 4, wobei die CSC (31) auf einer Oberseite des CSCC (30) angeordnet und elektrisch mit jedem der Schweißstücke (33, 34) verbunden ist.

6. Batteriemodul (50) nach Anspruch 5, wobei die elektrischen Verbindungen zwischen der CSC (31) und den Schweißstücken (33, 34) mindestens teilweise durch leitfähige Leitungen und/oder durch Durchkontaktierungen bereitgestellt sind.

7. Batteriemodul (50) nach einem der Ansprüche 4 bis 6, wobei ein Temperatursensor (40) auf einer Oberseite des CSCC (30) angeordnet ist und mindestens eines der Schweißstücke (33, 34) oder eine Metallisierung um mindestens eines der Schweißstücke (33, 34) überlappt.

8. Batteriemodul (50) nach einem der vorstehenden Ansprüche, wobei eine der Sammelschienen (17.1) einen Vorsprung umfasst, der den CSCC (30) überlappt, und wobei die restlichen Sammelschienen (17) nahe der CSCC (30) angeordnet sind.

9. Batteriemodul (50) nach einem der vorstehenden Ansprüche, wobei der CSCC aus einer biegsamen Leiterplatte, FCB, (30), die sich entlang einer Längsrichtung des Batteriemoduls (50) mit einer Breite kleiner als der Abstand zwischen benachbarten Sammelschienen (17) und/oder kleiner als der Abstand zwischen Klemmen (11, 12) einer Batteriezelle (10) erstreckt, gebildet ist.

10. Batteriemodul (50) nach den Ansprüchen 4 und 9, wobei die FCB (30) mindestens einen gebogenen Teilabschnitt (35) zwischen benachbarten Schweißstücken (33, 34) umfasst.

11. Batteriemodul (50) nach Anspruch 10, wobei der gebogene Teilabschnitt (35) in eine Höhenrichtung (Z) des Batteriemoduls (50) gebogen ist.

12. Verfahren zum Zusammenfügen eines Zellenüberwachungsschaltungsträgers, CSCC (30), der dazu konfiguriert ist, eine Zellenüberwachungsschaltung, CSC, (31) unterzubringen und einen Steckverbinder (32) zu umfassen, der dazu konfiguriert ist, eine Datenkommunikation mit der CSC (31) zu einem Batteriemodul (50) herzustellen, das eine Vielzahl aneinandergereihter Batteriezellen (10) umfasst, wobei jede der Batteriezellen (10) ein Zellengehäuse (13), eine Kappenanordnung (14), die auf dem Zellengehäuse (13) platziert ist, eine negative Zellenklemme (12) und eine positive Zellenklemme (11) umfasst, wobei das Verfahren die Schritte umfasst des:
Fixierens des CSCC (30) an der Unterseite eines Vakuumwerkzeugs (60) durch Anlegen eines Unterdrucks an dem CSCC (30) über das Vakuumwerkzeug (60),
Positionierens des fixierten CSCC (30) über dem Batteriemodul (50) über das Vakuumwerkzeug (60), und
elektrischen Verbindens des CSCC (30) mit der negativen Zellenklemme (12) einer Batteriezelle (10) und mit den Zellengehäusen (13) mindestens einiger der restlichen Batteriezellen (10) der Vielzahl von Batteriezellen (10), wobei die Zellengehäuse (13) die positiven Klemmen (12) bilden oder damit verbunden sind.

13. Verfahren nach Anspruch 12, wobei das Vakuumwerkzeug (60) eine Vielzahl von Schweiß-Durchgangslöchern (63) umfasst, die sich von einer oberen Seite (61) zu einer unteren Seite (62) des Vakuumwerkzeugs (60) erstrecken, und/oder wobei die untere Seite (62) des Vakuumwerkzeugs (60) mindestens einen gebogenen Abschnitt (64), der zwischen benachbarten Schweiß-Durchgangslöchern (63) angeordnet ist, umfasst.

14. Verfahren nach Anspruch 12 oder 13, wobei der CSCC (30) durch Schweißen mit einer negativen Klemme (12) einer äußersten Batteriezelle (11.1) und mit den Zellengehäusen (13) der restlichen Batteriezellen (10) verbunden ist, wobei mindestens ein gebogener Teilabschnitt (35) des CSCC (30) zwischen benachbarten Schweißstücken (33, 34) gebildet ist.

## Revendications

1. Module de batterie (50), comprenant :
une pluralité d'éléments de batterie (10) alignés, chacun des éléments de batterie (10) comprenant un boîtier d'élément (13), un ensemble capuchon (14) placé sur le boîtier d'élément (13), une borne d'élément négative (11) et une borne d'élément positive (12) ;
une pluralité de barres omnibus (17) disposées sur le dessus des ensembles capuchons (14), chacune des barres omnibus (17) étant configurée pour connecter électriquement les bornes d'éléments (11, 12) d'au moins deux éléments de batterie (10) ;
un support de circuit de supervision d'élément, CSCC, (30) configuré pour accueillir un circuit de supervision d'élément, CSC, (31) et comprenant un connecteur (32) configuré pour établir une communication de données avec le CSC (31),
dans lequel le CSCC (30) est configuré pour connecter électriquement le CSC (31) à la borne d'élément négative (12) d'un élément de batterie (10) et aux boîtiers d'éléments (13) d'au moins certains des éléments de batterie (10) restants de la pluralité d'éléments de batterie (10), les boîtiers d'éléments (13) constituant les ou étant connectés aux bornes positives (12).

2. Module de batterie (50) selon la revendication 1, dans lequel la pluralité d'éléments de batterie (10) alignés comprend une pluralité de sous-ensembles d'éléments de batterie (10) connectés en parallèle, les sous-ensembles d'éléments de batterie (10) étant connectés en série, et dans lequel le CSCC (30) est configuré pour connecter électriquement le CSC (31) à la borne d'élément négative (12) d'un élément de batterie (10) d'un sous-ensemble d'éléments de batterie (10) et au boîtier d'élément (13) d'au moins un élément de batterie (10) d'au moins certains sous-ensembles restants d'éléments de batterie (10).

3. Module de batterie (50) selon la revendication 1 ou 2, dans lequel le CSCC (30) est configuré pour connecter le CSC (31) aux boîtiers d'éléments (13) de chacun des éléments de batterie (10) restants.

4. Module de batterie (50) selon l'une quelconque des revendications précédentes, dans lequel une pluralité de plots de soudure (33, 34) est disposée sur un dessous du CSCC (30), dans lequel une première plage de soudure (34) est connectée à une borne négative (11) d'un élément de batterie (10.1) le plus extérieur, et les plots de soudure (33) restants sont connectés individuellement aux boîtiers d'éléments (13) des éléments de batterie (10) restants.

5. Module de batterie (50) selon la revendication 4, dans lequel le CSC (31) est disposé sur un côté du dessus du CSCC (30) et est connecté électriquement à chacun des plots de soudure (33, 34).

6. Module de batterie (50) selon la revendication 5, dans lequel les connexions électriques entre le CSC (31) et les plots de soudure (33, 34) sont au moins partiellement assurées par des lignes conductrices et/ou des trous traversants

7. Module de batterie (50) selon l'une quelconque des revendications 4 à 6, dans lequel un capteur de température (40) est disposé sur un côté du dessus du CSCC (30) et chevauche au moins un des plots de soudure (33, 34) ou une métallisation autour d'au moins un plot de soudure (33, 34) .

8. Module de batterie (50) selon l'une quelconque des revendications précédentes, dans lequel une des barres omnibus (17.1) comprend une saillie chevauchant le CSCC (30) et dans lequel les barres omnibus (17) restantes sont disposées à côté du CSCC (30).

9. Module de batterie (50) selon l'une quelconque des revendications précédentes, dans lequel le CSCC est formé d'une carte de circuit imprimé flexible, FCB, (30) s'étendant sur une direction de la longueur du module de batterie (50) avec une largeur inférieure à la distance entre des barres omnibus adjacentes (17) et/ou inférieure à la distance entre les bornes (11, 12) d'un élément de batterie (10).

10. Module de batterie (50) selon la revendications 4 et 9, dans lequel la FCB (30) comprend au moins une section incurvée (35) entre des plots de soudure (33, 34) adjacents.

11. Module de batterie (50) selon la revendication 10, dans lequel la section incurvée (35) est incurvée dans une direction de hauteur (Z) du module de batterie (50).

12. Procédé d'assemblage d'un support de circuit de supervision d'élément, CSCC (30), configuré pour accueillir un circuit de supervision d'élément, CSC, (31) et pour comprendre un connecteur (32) configuré pour établir une communication de données avec le CSC (31), sur un module de batterie (50), comprenant une pluralité d'éléments de batterie (10) alignés, chacun des éléments de batterie (10) comprenant un boîtier d'élément (13), un ensemble capuchon (14) placé sur le boîtier d'élément (13), une borne d'élément négative (12) et une borne d'élément positive (11), le procédé comprenant les étapes consistant à :
fixer le CSCC (30) sur le dessous d'un outil à vide (60) en appliquant une sous-pression au CSCC (30) par l'intermédiaire de l'outil à vide (60),
positionner le CSCC (30) fixé sur le module de batterie (50) par l'intermédiaire de l'outil à vide (60), et
connecter électriquement le CSCC (30) à la borne d'élément négative (12) d'un élément de batterie (10) et aux boîtiers d'éléments (13) d'au moins certains des éléments de batterie (10) restants de la pluralité d'éléments de batterie (10), le boîtiers d'éléments (13) constituant les ou étant connectés aux bornes positives (12) .

13. Procédé de la revendication 12, dans lequel l'outil à vide (60) comprend une pluralité de trous traversants de soudage (63) s'étendant d'un côté supérieur (61) à un côté inférieur (62) de l'outil à vide (60) et/ou dans lequel le côté inférieur (62) de l'outil à vide (60) comprend au moins une portion incurvée (64) disposée entre des trous traversants de soudage (63) adjacents.

14. Procédé de la revendication 12 ou 13, dans lequel le CSCC (30) est connecté par soudure à une borne négative (12) d'un élément de batterie (11.1) le plus extérieur, et aux boîtiers d'éléments (13) des éléments de batterie (10) restants, dans lequel au moins une section incurvée (35) du CSCC (30) est formée entre des plots de soudure (33, 34) adjacents.
